(19)

Europäisches
Patentamt
European
Patent Office
Office européen
des brevets

(11)     EP 3 396 721 A1

(12)                        EUROPEAN PATENT APPLICATION

(43) Date of publication:
**31.10.2018 Bulletin 2018/44**

(51) Int Cl.:
**H01L 31/0352** (2006.01)          **H01L 31/074** (2012.01)
**H01L 31/109** (2006.01)          **H01L 31/18** (2006.01)

(21) Application number: **18168794.8**

(22) Date of filing: **23.04.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.04.2017 US 201762488102 P**

(71) Applicant: **Chang, Yu-Chen
234 New Taipei City (TW)**

(72) Inventor: **Chang, Yu-Chen
234 New Taipei City (TW)**

(74) Representative: **Lucke, Andreas
Boehmert & Boehmert
Anwaltspartnerschaft mbB
Pettenkoferstrasse 22
80336 München (DE)**

(54)     **TWO-DIMENSIONAL ELECTRONIC DEVICES AND RELATED FABRICATION METHODS**

(57)     Various embodiments of a semiconductor device and related fabrication methods are disclosed. In one exemplary embodiment, the semiconductor device may include a substrate and a plurality of two-dimensional semiconductor films over the substrate, where a photogain of the two-dimensional films is above about $10^3$ when measured at room temperature. In another exemplary embodiment, a semiconductor device may comprise a substrate comprising nanorods or nanodots and a plurality of two-dimensional films disposed on the substrate.

Light shining

⬇ LT I

Light shining

Electrode (Au)

⬇ LT III

⬇ $I_{Au-ZnO}$     ZnO

⬇ $I_{ZnO-silicon}$

Substrate (Si)

Electrode

V

**Fig. 1**

EP 3 396 721 A1

## Description

## FIELD OF THE INVENTION

Various embodiments of the present disclosure relate generally to two-dimensional electronic devices and related fabrication methods. More specifically, particular embodiments of the present disclosure relate to group II-VI semiconductor films with high optoelectronic conversion efficiency and methods of depositing group II-VI semiconductor films on a semiconductor device.

## DESCRIPTION OF RELATED ART

Two-dimensional, group II-VI semiconductor films have become a field of increasing technological interest due to their unique properties and their potential applications in various types of optoelectronic devices, such as ultraviolet emission devices, light emitting diodes, laser diodes, solar cells, surface acoustic wave devices, photon detectors, transparent conductive films, waveguides, gas pressure sensors, microsensors, interfacial coatings for fiber strength enhancement, invisible thin film transistors, field emitters, field effect transistors, and photocatalysts. In particular, two-dimensional, group II-VI semiconductor films with excellent properties of piezoelectricity, electron conductivity, exciton binding energy, excitonic emission and tunable energy levels are considered promising building blocks for novel optoelectronic devices.

There are many growth techniques, including radio-frequency and direct-current sputtering, chemical vapor deposition, spray pyrolysis, electron cyclotron resonance-assisted molecular beam epitaxy, and pulsed laser deposition (PLD) methods. However, these high energy methods typically result in broad material interface damage, significant stoichiometric non-uniformity in films, and structure imperfections such as, for example, micro pinholes and point-defects.

For example, in case of PLD films, the degree of orientation may be influenced by the deposition conditions, such as temperature, background gas composition and pressure, and kinetic energy of the plume particles. Kinetic energy is mainly dependent upon the laser power density because the distribution of plasma and species can be varied by levels of laser fluence. However, the problems relating to efficient doping and controlling the optoelectronic properties of the films have remained as technological issues to be solved. With the continual trend towards scaling down modern electronic devices to micro- and nano-levels, such issues may become even more severe and can degrade the material quality tremendously.

Accordingly, there is a need for an improved two-dimensional, group II-VI semiconductor films and related methods that may overcome one or more of the issues and/or problems discussed above. In particular, there is a need for improved growth/deposition methods that can improve the material properties and performances of group II-VI semiconductor films.

## SUMMARY

As an alternative deposition method, atomic layer deposition (ALD) method which enables layer-by-layer growth of high-quality films through self-limiting surface reactions is considered. The ALD method has numerous advantages over other thin-film techniques, such as, for example, good uniformity and conformality, accurate atomic-scale thickness controllability, perfect stoichiometric uniformity, low impurity contamination, and low deposition temperature (below 400 °C) which enables the utilization of temperature sensitive substrates, for example, biological materials and polymers that could be destroyed or compromised at conventional process temperature.

Moreover, the ALD method has strong capabilities to control the optoelectronic characteristics of the ALD-derived semiconductor thin films, including Hall carrier mobility, electrical resistivity, electrical conductivity, light transparency, and photon-electron conversion efficiency. Therefore, ALD fabricating technique can be advantageous in depositing two-dimensional semiconductor films with greater control over layer optoelectronic properties.

To attain the advantages and in accordance with the purpose of the present disclosure, as embodied and broadly described herein, one exemplary aspect consistent with the present disclosure may provide a semiconductor device comprising a substrate and a plurality of two-dimensional films on the substrate, wherein a photogain of the two-dimensional films is above about $10^3$ when measured at room temperature. In some exemplary aspects, the two-dimensional films may comprise group II or group VI material. For example, the two-dimensional films may comprise Zinc and Oxide. In another exemplary aspect, the two-dimensional films may be ZnO films, and the thickness of the ZnO films is below about 100 nm. The thickness of the ZnO films may be below about 5 nm. In still another exemplary aspect, the semiconductor device may further comprise an electrode disposed on the two-dimensional films. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode may be about 2 $\mu$m.

According to another exemplary aspect, the semiconductor device may further comprise an electrode, wherein the electrode is disposed on the substrate. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode can be about 2 $\mu$m. In one exemplary aspect, the substrate may comprise group II, group III, group V, or group VI material. For example, the substrate may comprise silicon, boron, or phosphorus.

The silicon substrate is an n-type silicon substrate or p-type silicon substrate..

Another exemplary aspect may provide a semiconductor device comprising a substrate comprising nanorods and a plurality of two-dimensional films disposed on the nanorods substrate. The two-dimensional films may comprise group II or group VI material. For example, the two-dimensional films may comprise Zinc and Oxide. The thickness of the ZnO films may be below about 100 nm. For example, the thickness of the ZnO films may be below about 5 nm. In still another exemplary aspect, the semiconductor device may further comprise an electrode disposed on the two-dimensional films. In another exemplary aspect, the semiconductor device may comprise an electrode disposed on the two-dimensional films on the nanorods substrate. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode is about 2 $\mu$m. According to another exemplary aspect, the semiconductor device may further comprise an electrode, wherein the electrode is disposed on the nanorod substrate. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode can be about 2 $\mu$m. The nanorods substrate comprises group II, group III, group V or group VI material. The nanorods substrate may comprise silicon, boron, or phosphorus. The nanorod substrate is an n-type silicon nanorod substrate or p-type silicon nanorod substrate.

Still another exemplary aspect may provide semiconductor device comprising a substrate comprising nanodots and a plurality of two-dimensional films disposed on the nanodots substrate. The two-dimensional films may comprise group II or group VI material. For example, the two-dimensional films may comprise Zinc and Oxide. In still another exemplary aspect, the two-dimensional films may be ZnO films, and the thickness of the ZnO films is below about 100 nm. The thickness of the ZnO films may be below about 5 nm. In still another exemplary aspect, the semiconductor device may further comprise an electrode disposed on the two-dimensional films. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode may be about 2 $\mu$m. According to another exemplary aspect, the semiconductor device may further comprise an electrode, wherein the electrode is disposed on the nanodot substrate. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode may be about 2 $\mu$m. The nanodot substrate comprises group II, group III, group V or group VI material. The nanodot substrate may comprise silicon, boron, or phosphorus. The silicon nanodot substrate is an n-type silicon substrate or p-type silicon substrate.

According to certain exemplary aspects, a semiconductor device may comprise a substrate and a plurality of doped two-dimensional films, wherein the doped two-dimensional films have an average transmittance in the visible wavelength range exceeding 95 %, a mobility of above about $10^2$ cm$^2$ V$^{-1}$ s$^{-1}$, and a resistivity below about $10^{-5}$ $\Omega$-cm. In some exemplary aspects, the doped two-dimensional films may be doped by group III or group V material. For example, in an exemplary aspect, the doped two-dimensional films may comprise a ZnO film. In another exemplary aspect, the doped two-dimensional films may comprise Aluminum.

In still another exemplary aspect, a semiconductor device may comprise a substrate comprising nanorods and a plurality of doped two-dimensional films disposed on the nanorods substrate. The doped two-dimensional films may comprise group II or group VI material and group III or group V material. In some exemplary aspects, the doped two-dimensional films may comprise Zinc, Oxide, and Aluminum. In another exemplary aspect, the semiconductor device may further comprise an electrode disposed on the doped two-dimensional films on the nanorods substrate. The electrode can be Fe, Co, Ni, Cu, Zn, Ag, Pt, Au, Al, In, Ti, Mn, Ge, Pb or C. The thickness of the electrode may be between 50 nm to 2000 nm. The thickness of the electrode may be about 2 $\mu$m. According to another exemplary aspect, the semiconductor device may further comprise an electrode, wherein the electrode is disposed on the nanorod substrate. The electrode can be Fe, Co, Ni, Cu, Zn, Ag, Pt, Au, Al, In, Ti, Mn, Ge, Pb or C. The thickness of the electrode may be between 50 nm to 2000 nm. The thickness of the electrode is about 2 $\mu$m. The nanorods substrate comprises group II, group III, group V or group VI material. The nanorods substrate may comprise silicon, boron, or phosphorus. The nanorod substrate is an n-type silicon nanorod substrate or p-type silicon nanorod substrate

According to another exemplary aspect, a semiconductor device may comprise a substrate comprising nanodots and a plurality of doped two-dimensional films disposed on the nanodots substrate. The doped two-dimensional films may comprise group II or group VI material and group III or group V material. For example, the doped two-dimensional films may comprise Zinc, Oxide, and Aluminum. In one exemplary aspect, the semiconductor device may comprise an electrode disposed on the doped two-dimensional films on the nanodots substrate. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode is about 2 $\mu$M.

According to another exemplary aspect, the semiconductor device may further comprise an electrode, wherein the electrode is disposed on the nanodot substrate. The electrode can be Fe, Co, Ni, Cu, Zn, Ag, Pt, Au, Al, In, Ti, Mn, Ge, Pb or C. The thickness of the electrode may be between 50 nm to 2000 nm. For example, the thickness of the electrode may be about 2 μm. The nanodot substrate comprises group II, group III, group V or group VI material. The nanodot substrate may comprise silicon, boron, or phosphorus. The nanorod substrate is an n-type silicon nanorod substrate or p-type silicon nanodot substrate.

Another exemplary aspect consistent with the present disclosure may provide a method of growing a two-dimensional film on a semiconductor device. The method may comprise providing a substrate, controlling a temperature to above about 50 °C, supplying a group IV material, stopping the supply of the group IV material, supplying a group II material, stopping the supply of the group II material, and forming a group II-VI two-dimensional film on the substrate. In some exemplary aspects, the method may comprise, after stopping the supply of the group II material, setting the pressure to a range of about $10^{-1}$ to $10^{-4}$ torr. In one exemplary aspect, forming the group II-VI two-dimensional film may comprise forming the group II-VI two-dimensional film with a less than about 100 nm thickness on the substrate. In various exemplary aspects, the group II-VI two-dimensional film may comprise a ZnO film. In still another exemplary aspect, providing the substrate may comprise providing the substrate in a ALD reaction chamber. Further, the method may comprise controlling the temperature of the ALD reaction chamber to above about 50 °C, preferably to a range of about 50 °C ~ 400 °C, and controlling a gas pressure of the ALD reaction chamber to a range of about $10^{-1}$ to $10^{-4}$ torr.

According to another exemplary aspect, consistent with the present disclosure, a method of growing a doped two-dimensional film on a semiconductor device is provided. The method may comprise providing a substrate, controlling the temperature to above about 50 °C, supplying a group IV material, stopping the supply of the group IV material, supplying a group II material, stopping the supply of the group II material, supplying a group III or group V material, stopping the supply of the group III or group V material, and forming a II-VI two-dimensional film containing the group III or group V doped material on the substrate. In another exemplary aspect, the method may further comprising, after stopping the supply of the group II material, setting the pressure to a range of about $10^{-1}$ to $10^{-4}$ torr. In still another exemplary aspect, forming the group II-VI two-dimensional film may comprise forming the group II-VI two-dimensional film with a less than about 100 nm thickness on the substrate. Various exemplary aspects of the method may comprise providing a substrate in a ALD reaction chamber, controlling a temperature of the ALD reaction chamber to a range of about 50 °C ~ 400 °C, and/or controlling a gas pressure of the ALD reaction chamber to a range of about $10^{-1}$ to $10^{-4}$ torr.

Additional objects and advantages of the invention will be set forth in part in the description which follows, and in part will be obvious from the description, or may be learned by practice of the invention. The objects and advantages of the invention will be realized and attained by means of the elements and combinations particularly pointed out in the appended claims.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this specification, illustrate various embodiments consistent with the present disclosure, and, together with the description, serve to explain the principles of the invention.

Fig. 1 is a schematic diagram illustrating a cross-sectional view of a Au/ZnO/substrate (Si) device, according to one exemplary embodiment of the present disclosure.

Fig. 2 is a schematic diagram illustrating a plan view of the Au/ZnO/substrate (Si) device of Fig. 1.

Fig. 3 is a schematic diagram illustrating a cross-sectional view of a Au/ZnO-nanorods/substrate (Si) device, according to another exemplary embodiment.

Fig. 4 is Scanning Electron Microscopy (SEM) images of (a) ZnO nanorods and (b) ZnO nanorods coated with Au electrode.

Fig. 5 is a schematic diagram illustrating a cross-sectional view of a Au/ZnO-nanodots/substrate (Si) device, according to still another exemplary embodiment.

Fig. 6 is a current-voltage graph, illustrating characteristic of the Au/ZnO/substrate (Si) device for different number of ZnO layers under applied bias without light shining.

Fig. 7 is a graph showing the photocurrent of Au/ZnO layer as a function of applied bias for different number of ZnO layers at optical power of about 3.8 mW while light shining on Au electrode.

Fig. 8 is a graph showing the photocurrent of ZnO/substrate (Si) as a function of applied bias for different number of ZnO layers at optical power of about 3.8 mW while light shining on ZnO layer.

Fig. 9 is a graph showing the photogain of Au/ZnO/substrate (Si) as a function of applied bias for different number of ZnO layers at optical power of about 3.8 mW.

Fig. 10 is a graph showing the resistivity and mobility of Al-doped ZnO semiconductor thin films with different growth temperature from 50 °C to 300 °C.

Fig. 11 is a graph showing the optical transmittance spectra of Al-doped ZnO semiconductor thin films with different deposition temperature from 50 °C to 300 °C.

Fig. 12 is a flow diagram illustrating an exemplary method of growing two-dimensional, group II- VI semiconductor films on a semiconductor device.

Fig. 13 is a flow diagram illustrating another exemplary method of growing two-dimensional, group II-VI semiconductor films on a semiconductor device.

Fig. 14 is a flow diagram illustrating another exemplary method of growing two-dimensional, group II-VI semiconductor films containing a group III or group V material on a semiconductor device.

Fig. 15 is a flow diagram illustrating another exemplary method of growing two-dimensional, group II-VI semiconductor films containing a group III or group V material on a semiconductor device

Fig. 16 is a graph illustrating photoluminescence (PL) spectra of exemplary Al-doped ZnO semiconductor films with different growth temperatures from 50 °C to 300 °C.

Fig. 17 is a graph illustrating X-ray Powder Diffraction (XRD) spectra of exemplary Al-doped ZnO semiconductor films with different growth temperatures from 50 °C to 300 °C. The inset picture is the lattice constant as the function of deposition temperature.

## DESCRIPTION OF THE EMBODIMENTS

Reference will now be made in detail to exemplary embodiments consistent with the present invention, examples of which are illustrated in the accompanying drawings. Wherever possible, the same reference numbers will be used throughout the drawings to refer to the same or like parts.

Photodetectors (PD) are one of the basic building blocks of an optoelectronic link, where it performs optical-to-electrical signal conversion. Development of Si-based PDs (Si-PDs) for telecommunication wavelengths (1.3-1.6 $\mu$m) based on the mature CMOS technology is an essential step for monolithic, on-chip, optoelectronic integration. While Si-PDs are widely employed in the visible spectral range (0.4-0.7 $\mu$m), they are not suitable for detecting near-infrared (NIR) radiation above 1.1 $\mu$m because the energy of NIR photons at telecommunication wavelengths (0.78-0.95 eV) is not sufficient to overcome the Si bandgap (indirect, 1.12 eV) and induces photogeneration of electron-hole pairs (i.e., no photocurrent ($I_{ph}$) is generated). Over the years, the Si photonics industry has developed solutions to overcome this deficiency by combining Ge (bandgap 0.67 eV) with Si and integrating compound (III-V) semiconductors on the Si chip using wafer bonding techniques. While these approaches provide a path toward photodetection in the telecommunication spectral range, they either require advanced and complex fabrication processes in the case of SiGe devices or rely on group III-V material systems not compatible with standard CMOS technology. Motivated by the need of developing Si-based PDs for telecommunication wavelengths, several approaches were proposed to date. These include two-photon absorption (TPA), defect mediated band-to-band photogeneration via midbandgap localized states, deposition of polysilicon for NIR absorption, and enhancement by optical cavities. However, in the cases of defect-mediated and poly-Si PDs, the overall concentration of defects in the Si lattice affects both $I_{ph}$ and the leakage (dark) current $I_{dark}$. For example, a higher density of defects increases both the sub-bandgap optical absorption and thermal generation processes, thus increasing both $I_{ph}$ and $I_{dark}$. As a result, PDs with reduced defect concentration are typically needed to be coupled to optical resonators to amplify the optical power and to enhance the absorption without increasing either device length or defect density. On the other hand, nonlinear optical process, such as TPA, could potentially contribute to all-Si NIR-PDs, but this approach requires increased optical power with respect to linear absorption, or PD integration with high quality factor cavities, to achieve enhanced photon density.

An alternative exploits internal photoemission (IPE) in a Schottky diode. In this configuration, photoexcited ("hot") carriers from the metal are emitted to Si over a potential barrier height $\Phi_B$, called Schottky barrier (SB), which exists at the metal-Si interface. In Si, the injected carriers are accelerated by an electric field in the depletion region of a Schottky diode and then collected as a photocurrent at the external electrical contacts. Typically, a SB is lower (0.2-0.8 eV) than the Si bandgap, thus allowing photodetection of NIR photons with energy hv > $\Phi_B$. The advantages of Schottky PDs are the simple material structure, easy and inexpensive fabrication process, straightforward integration with CMOS technology, and broadband (0.2-0.8 eV) operation.

One of the disadvantages is the limited IPE quantum yield, i.e., the number of carriers emitted to Si divided by the number of photons absorbed in the metal, which is typically less than 1%. This is mainly due to the momentum mismatch between the electron states in the metal and Si, which results in specular reflection of hot carriers upon transmission at the metal-Si interface.

One way to improve the $R_{ph}$ and IQE in Schottky PDs is to confine light at the metal-Si interface by coupling to plasmonic modes. The role of plasmonic confinement in enhancing the IPE efficiency in Si Schottky PDs was intensively studied in various Metal-Si plasmonic structures. Several near-infrared Si plasmonic Schottky PDs have been demonstrated, exploiting both localized plasmons and guided surface plasmons polaritons (SPP).

Yet, in these devices, the $Rph$ reported to date does not exceed few tens mA/W with maximum IQE of about 1%. These values are significantly below that of SiGe PDs (Rph of about 0.4 - 1A/W and IQE of about 60-90%). Consequently, $Rph$ of Schottky PDs should be further improved both by developing advanced device designs or using novel CMOS compatible materials.

The electrical transport properties, such as saturation current, barrier height, and the ideality factor, can be described by using the current-voltage ($I$-$V$) relation in the thermionic emission model,

$$I = I_0 \left[ exp\left(\frac{qV}{nkT}\right) - 1 \right],$$

where n is ideality factor, q is the electron charge, $V$ is the applied voltage, k is the Boltzmann constant, and T is absolute temperature.

The saturation current $I_o$ is given by

$$I_0 = AA^*T^2 exp(-\frac{q\Phi_b}{kT}),$$

where $\Phi_b$ is the effective Schottky barrier height at zero bias, $A^*$ is the Richardson constant, A is the effective area, and $n$ is the ideality factor determined from the slope of the linear region of the forward bias In $I$ - V characteristic through the relation:

$$n = \frac{q}{kT} dV/d\ln I \,,$$

where $I_0$ is determined from the intercept of In $I$ vs $V$ curve on the $y$-axis. In addition, the barrier height can be obtained from the equation:

$$q\Phi_b = kT \ln(\frac{AA^*T^2}{I_0}).$$

The quantum yield is often called internal quantum efficiency (IQE) and given as

$$IQE = \frac{I_{ph}}{P_{abs}} \times \frac{h\nu}{q}$$

where $P_{abs}$ is the absorbed optical power, hv is the photon energy, q is the electron charge, and $I_{ph}/P_{abs}$ is the PD responsivity ($R_{ph}$) in units of A/W.

The photogain (PG) of the device is used to describe the effect of light confinement and absorption at the interface of the device. In the case of the Au/ZnO/substrate (Si) electrical device, the photogain is calculated by dividing the photocurrent of the Au/ZnO layer by the photocurrent of the ZnO/substrate (Si) and given as:

$$PG = \frac{I_{Au-ZnO}}{I_{ZnO-Substrate}}$$

where $I_{Au-Zno}$ and $I_{Zno-Substrate}$ are the photocurrent of the Au/ZnO layer and the photocurrent of ZnO/ substrate (Si), respectively. The higher the value of the photogain is, the better the device's light confinement and absorption ability are to perform.

Another important performance metric of PDs is the normalized photo-dark-current ratio, NPDR = $R_{Ph}/I_{dark}$. The larger the NPDR is, the better PD noise rejection and ability to perform are when interference (noise) is present. To achieve higher NPDR, $I_{dark}$ must be reduced and $R_{ph}$ must be increased.

In telecommunication applications, where power consumption and signal-to-noise ratio (SNR) are parameters of great importance for achieving energy efficient data transmission with reduced error rate, PDs should be operated near zero bias, which, in turn, limits $R_{ph}$. Even though PDs can perform in photovoltaic mode at zero bias with zero dark current, the conductance of a group II-VI semiconductor film can lead to enhanced thermal noise as a result of reduced channel resistance. A promising route to increase $R_{ph}$, while minimizing $I_{dark}$, is to create a Schottky junction with rectifying characteristics (i.e., a diode) at the metal-Si layer. By operating a Schottky diode in reverse bias (photoconductive mode), $I_{dark}$ is suppressed compared to $I_{ph}$, while the entire Schottky contact area contributes to photodetection.

Several PDs have been reported to date, operating at telecommunication wavelengths and integrating on-chip metal with Si photonics, based on metal-graphene-metal (MGM) structures evanescently coupled to Si waveguides. In these cases, the guided mode approach enables longer interaction between single-layer graphene (SLG) and the optical waveguide modes than free-space illumination. This raises the optical absorption in PD beyond 2.3% and, by increasing the interaction length, 100% light power can be absorbed and contribute to $I_{ph}$. Nevertheless, because of the evanescent coupling, the typical length needed to achieve nearly complete absorption in PDs is about 40 - 100 $\mu$m.

However, for on-chip optoelectronic integration, where scalability, footprint, and cost play an important role, the development of miniaturized, simple to fabricate, Si-based PDs for telecommunication applications with $R_{ph}$ comparable to the SiGe devices currently employed in Si photonics, is needed

The increase in the bandgap expansion induced by the quantum confinement is a well-known phenomenon. It is suggestive that the peak shift of PL emission is due to the size-confinement effect. According to the effective mass approximation theory, the bandgap energy E at different film thickness $t$ is given by $E (t) = E_{ZnO,bulk} + F/t^2$, where F = 6 eV-nm$^2$ is the quantum confinement constant, and $E_{ZnO,bulk}$ is the band gap energy of bulk ZnO ($\sim$ 3.37 eV). According to the Burstein-Moss effect, the bandgap energy should increase with the carrier density at a rate of $n^{2/3}$, where n is the carrier density.

Consistent with the present disclosure, the group II-VI semiconductor film can be used in solar cell devices such as crystalline solar cells, thin film solar cells, dye-sensitized solar cells, and electronic components. In a traditional solar cell, photons of sunlight knock electrons out of a semiconductor into a circuit, making useful electric power, but the efficiency of the process is quite low due to low photon absorption. The group II-V semiconductor film can absorb more photons, potentially offering a boost in higher photon-electron conversion efficiency than conventional semiconductors.

Also consistent with the present disclosure, the group II-V semiconductor film can also be used to make smaller and more efficient charge-coupled devices (CCDs) for applications where conventional devices are too big and clumsy. CCDs can be image-detecting chips in imaging devices, such as, for example, digital cameras and webcams, that operate in a similar way as solar cells, by absorbing more photons and converting into patterns of electrical signals to enhance resolution of CCDs.

Also consistent with the present disclosure, the group II-V semiconductor film can be used in field emitters, field effect transistors, and transparent thin film transistors (TFT) due to its ultrahigh mobility which is necessary for high resolution. Advantages associated with a large band gap include higher breakdown voltages, ability to sustain large electric fields, lower noise generation, and high temperature and high-power operation. The electron transport in semiconductors can be considered for low and high electric fields. At sufficiently low electric fields, the energy gained by the electrons from the applied electric field is small compared to the thermal energy of electrons, and therefore, the energy distribution of electrons is unaffected by such a low electric field. Since the scattering rates determining the electron mobility depend on the electron distribution function, electron mobility remains independent of the applied electric field, and Ohm's law is obeyed.

Moreover, when the electric field is increased to a point where the energy gained by electrons from the external field is no longer negligible compared to the thermal energy of the electron, the electron distribution function changes significantly from its equilibrium value. These electrons become hot electrons characterized by an electron temperature larger than the lattice temperature. Furthermore, as the dimensions of the device are decreased to submicron range, transient transport occurs when there is minimal or no energy loss to the lattice during a short and critical period of time, such as during transport under the gate of a field-effect transistor or through the base of a bipolar transistor. The transient transport is characterized by the onset of ballistic or velocity overshoot phenomenon. Since the electron drift velocity is higher than its steady-state value, one can design a device operating at frequencies exceeding those expected from linear scaling of dimensions.

Also consistent with the present disclosure, the group II-V semiconductor film can be used in laser diodes, light emitting diodes (LEDs), and organic light emitting diodes (OLED). Conventionally, fabrication of two-dimensional structures has been the focus of semiconductor laser to decrease the threshold for lasing. Efficient stimulated emission may be obtained from the II-V semiconductor film structures since the transfer integral at the band edge is larger than that of the bulk semiconductor. Excitonic emission may also be used to obtain efficient lasing, which may be realized for a group II-V semiconductor film due to its larger exciton binding energy compared to other semiconductors. Exciton-exciton scattering-induced stimulated emission is very important for the realization of low-threshold lasers since it occurs at a threshold lower than that for the electron-hole plasma recombination. The demonstration of stimulated emission with excitonic origin paves the way for the realization of laser diodes, light emitting diodes and organic light emitting diodes (OLED) based on group II-V semiconductors.

Also consistent with the present disclosure, the group II-V semiconductor film can be used in gas pressure sensors, surface acoustic wave devices, and transducers due to its surface reactivity hardness, stiffness and piezoelectric properties. The group II-V semiconductor film has the highest piezoelectric tensor. This property makes it a technologically important material for gas pressure sensors, surface acoustic wave devices and transducers, which require a large electromechanical coupling. It has been shown that the large piezoelectric tensor of a group II-V semiconductor film is due to the low value of its clamped-ion contribution (reducing the cancelation effect).

Also consistent with the present disclosure, the group II-V semiconductor film can be used in photon detectors due to their fast photoresponse time, low noise performance, and low quantum efficiency.

Also consistent with the present disclosure, the group II-V semiconductor film can be used in the biosensor devices which have temperature sensitive substrates such as biological materials and polymers. It can significantly enhance the efficiency of the device due to high thermal/chemical stability, non-toxic nature, good light confinement and light absorption.

Also consistent with the present disclosure, the group II-V semiconductor film can be used in transparent conductive films due to its high visible transmittance of more than 95 % and low electrical resistivity of below about $10^{-5}$ $\Omega$-cm.

Also consistent with the present disclosure, the group II-V semiconductor film can be used in microsensors due to its good light confinement and high absorption ability.

Also consistent with the present disclosure, the group II-V semiconductor film can be used in nanophotohenerators due to its high light confinement and high absorption ability which enable to use to increase the conversion efficiency of photon-electron efficiency

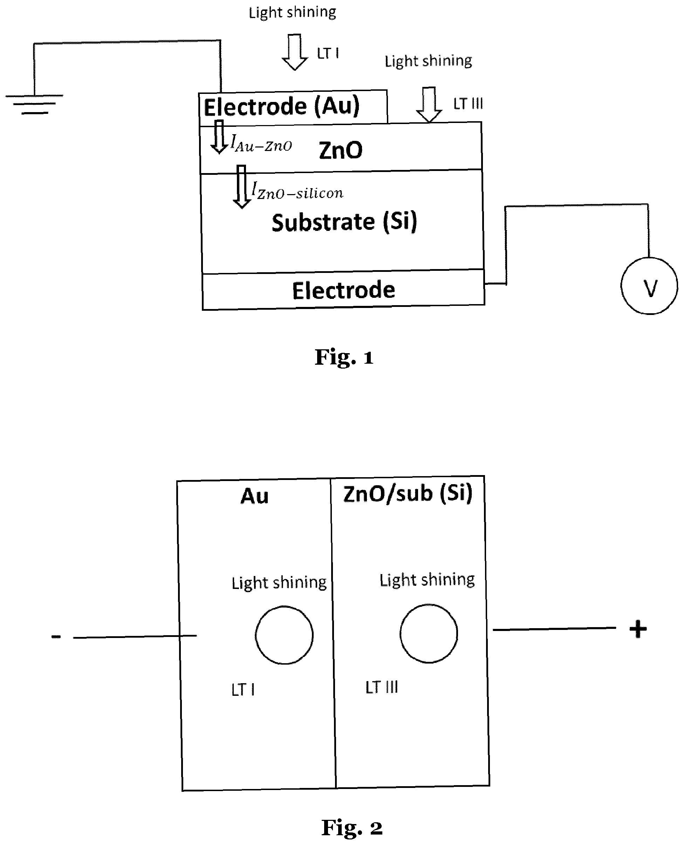

According to various exemplary aspects of the present disclosure, Figs. 1 and 2 schematically illustrate an exemplary embodiment of a semiconductor device having two-dimensional, group II-VI semiconductor films. While the semiconductor device of the present disclosure will be described in connection with group II-VI semiconductor films of ZnO, it should be understood that the semiconductor device may be formed with other group II-VI semiconductor films.

Fig. 1 is a cross-sectional view of an exemplary Au/ZnO/substrate (Si) device, and Fig. 2 is a plan view of the Au/ZnO/substrate (Si) device. The Au/ZnO/substrate (Si) device comprises a Silicon substrate and a ZnO layer deposited on the Silicon substrate. The ZnO layer may comprises a plurality of ZnO films. In this exemplary embodiment, the thickness of ZnO may be about 5 nm, and the thickness of Au electrode may be about 2 $\mu$m.

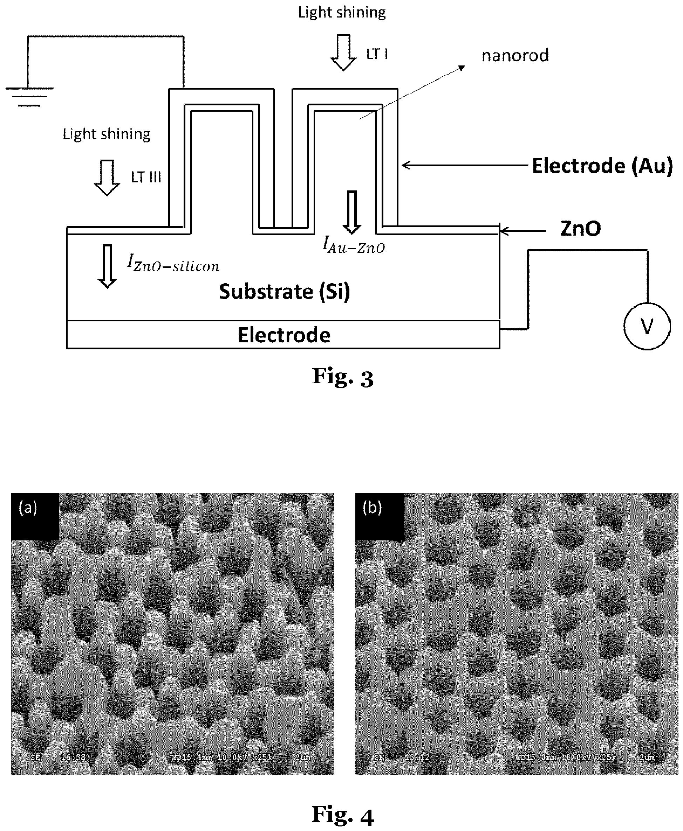

Fig. 3 schematically illustrates another exemplary embodiment of a semiconductor device having a substrate comprising nanorods and a plurality of two-dimensional films disposed on the nanorods substrate. In one exemplary embociment, the semiconductor device may comprise a Au/ZnO nanorods/substrate (Si) device with the size of nanorod in the range from 0 - 2000 nm. In some exemplary embodiments, the thickness of ZnO may be about 3 nm, and the thickness of Au electrode may be about 1 $\mu$m disposed on the nanorods substrate.

Fig. 4 are SEM images of (a) two-dimensional ZnO films deposed on the silicon nanorods substrate with the size of nanorod of around 250 nm, and (b) ZnO nanorods coated with a Au electrode where the thickness of Au electrode is around 0.5 $\mu$m.

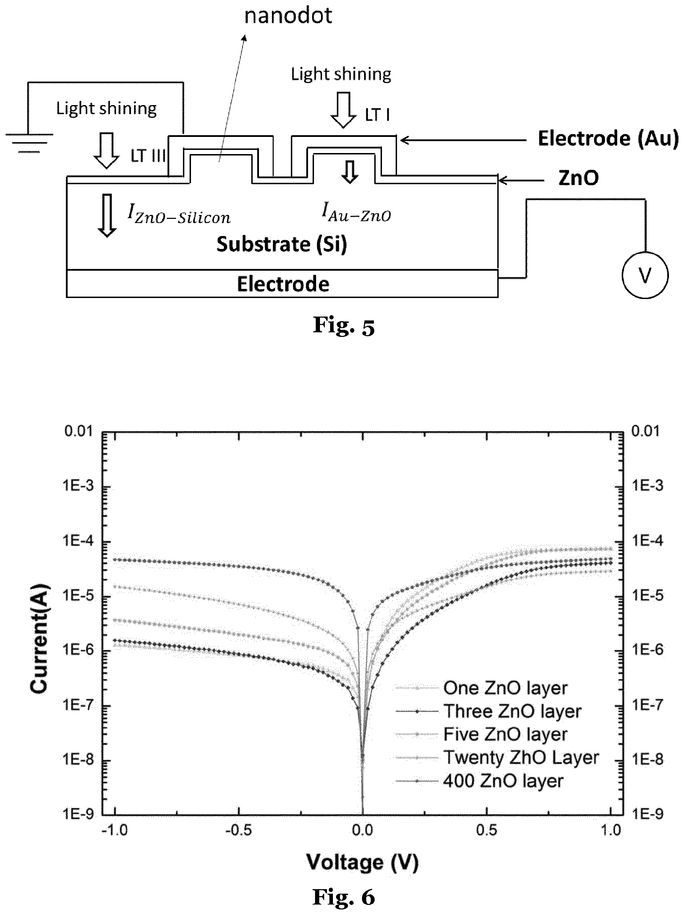

Fig. 5 is a schematic diagram illustrating a cross-sectional view of a Au/ZnO-nanodots/substrate (Si) device with the size of nanodot in the range of 0 - 100 nm. In this device, the thickness of ZnO may be about 2 nm and the thickness of Au electrode may be about 0.05 $\mu$m disposed on the nanodots substrate.

Fig. 6 illustrates a detailed IV characteristic of the Au/ZnO/substrate (Si) device for different number of two-dimensional ZnO films under applied bias without light shining. Here, the thickness of one ZnO film is equal to about 0.25 nm. The measurements were made at room temperature. It can be observed that the leakage current is of the order of around $10^{-6}$ to $10^{-7}$ A for ZnO film with the number of layers below five layers. With increasing the number of layers to above five layers, the leakage current only has $10^{-6}$ A. These values are very small when compared to conventional devices.

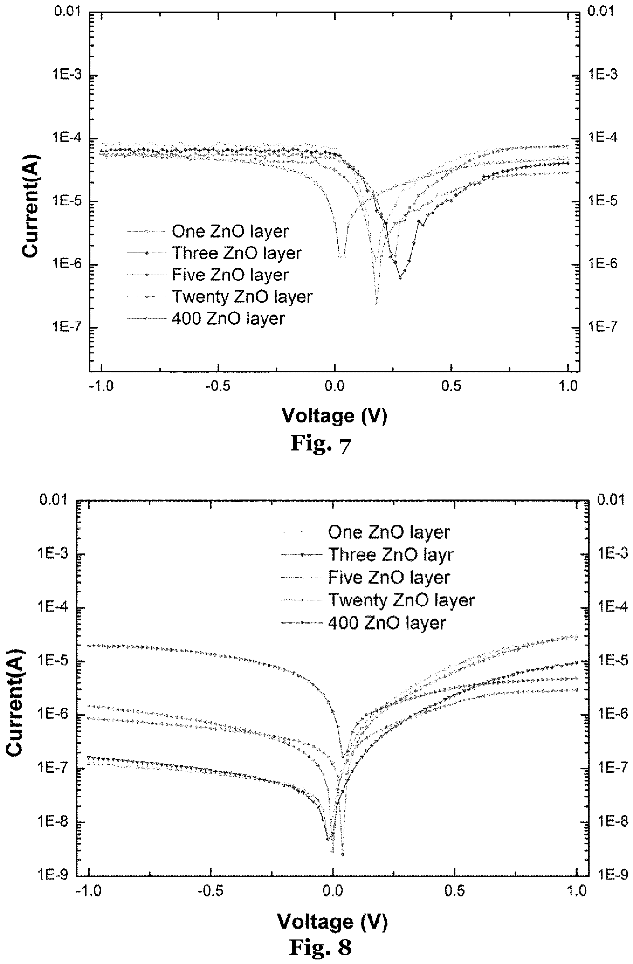

Fig. 7 illustrates the photocurrent of Au/ZnO layer as a function of applied bias for different number of ZnO films at optical power of about 3.8 mW while shining light on Au electrode. Measurements were made at room temperature. The photocurrent is mainly obtained from the ZnO film. This light shining mode is called LT I mode. It can be observed that the photocurrent in the different number of ZnO layers from one to 400 ZnO layers is of the order of about $10^{-4}$ to $10^{-5}$ A. These values are quite large when compared to conventional devices.

Fig. 8 illustrates the photocurrent of ZnO/substrate (Si) as a function of applied bias for different number of ZnO films at optical power of about 3.8 mW while shining light on ZnO layer. Measurements were made at room temperature. The photocurrent is mainly obtained from the Si substrate. This light shining mode is called LT III mode. Since the Si substrate is not a good light absorbing material, the photocurrent is quite small.

It is clearly observed that the photocurrent in the different number of ZnO layers from 1 to 20 layers is of the order of about $10^{-6}$ to 10-7 A, which is close to the leakage current value.

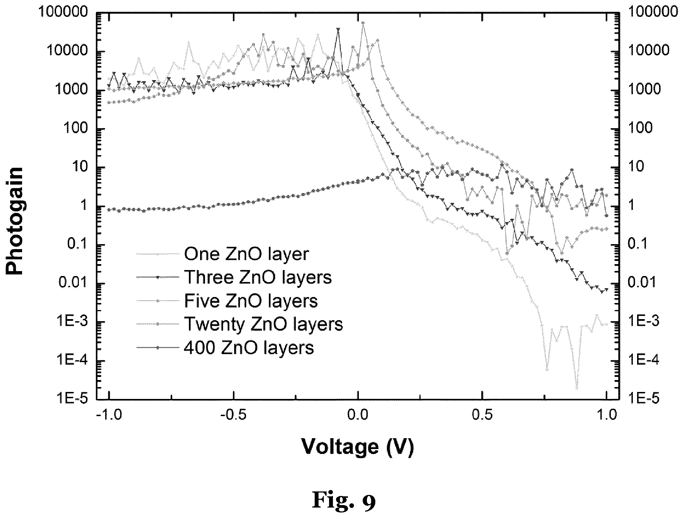

Fig. 9 illustrates the photogain of Au/ZnO/substrate (Si) device as a function of applied bias for different number of ZnO films at optical power of about 3.8 mW. Measurements were made at room temperature. It is clearly observed that the photogain values in the different number of ZnO layers from one to twenty layers is of the order of about $10^3$ to $10^4$, which is quite large compared to conventional devices that are about one to ten. Therefore, it shows this device has a good light confinement and absorption ability.

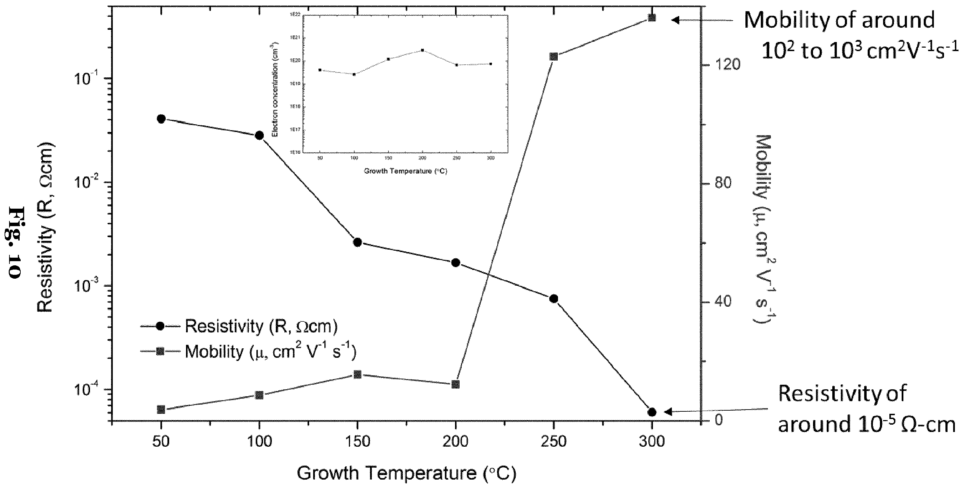

Fig. 10 illustrates the resistivity and mobility of Al-doped ZnO semiconductor thin films with different growth temperature from 50 °C to 300 °C. The present device shows an unprecedented mobility of above about $10^2$ cm$^2$V$^{-1}$s$^{-1}$ where the corresponding resistivity is below about $10^{-5}$ $\Omega$-cm. The inset picture is the carrier concentration (in the range of $10^{20}$ to $10^{23}$ cm$^{-3}$) as the function of growth temperature. It is clearly observed that after 200 °C, the mobility significantly increases to above about $10^2$ cm$^2$V$^{-1}$s$^{-1}$, exhibiting good conductive properties. Moreover, the resistivity values also decrease in the order of $10^{-5}$ to $10^{-6}$ $\Omega$-cm when the growth temperature increases to above 200 °C.

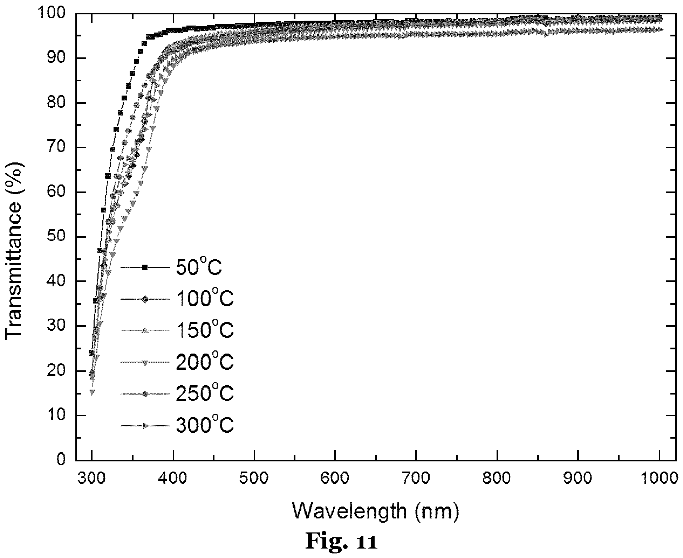

Fig. 11 illustrates the optical transmittance spectra of Al-doped ZnO semiconductor thin films with different deposition temperature from 50 °C to 300 °C. It is clearly observed that more than 95% of light can pass through this Al-doped ZnO semiconductor thin films, exhibiting good optical qualities. The average transmittance in the visible wavelength range ($\sim$ 400 nm to 800 nm) exceeds 95%.

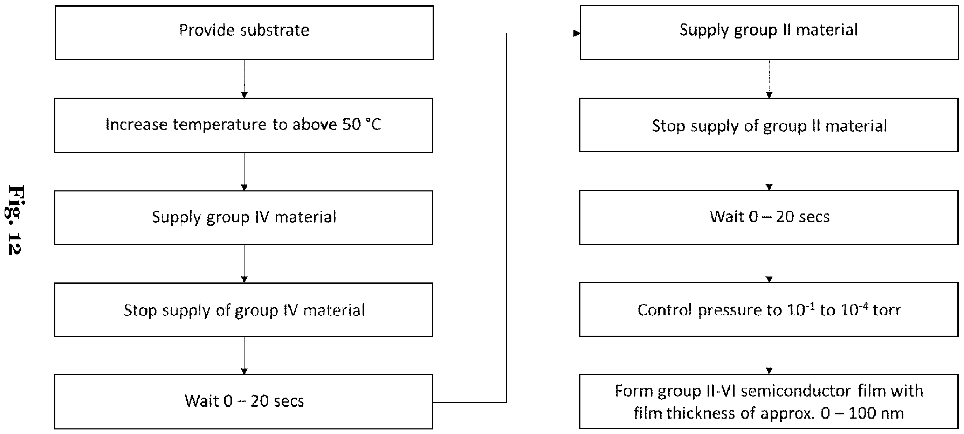

Fig. 12 illustrates an exemplary method of growing two-dimensional, group II-VI semiconductor films on a semiconductor device. The method includes: (a) providing a substrate in an ALD reaction chamber; (b) controlling a temperature of the ALD reaction chamber to a range above of about 50 °C (e.g., about 50 °C $\sim$ 400 °C); (c) supplying a group IV material; (d) stopping the supply of the group IV material; (e) waiting 0 $\sim$ 20 secs after stopping the supply of the group IV material; (f) supplying a group II material; (g) stopping the supply of the group II material; (h) waiting 0 $\sim$ 20 secs after stopping the supply of the group II material; (i) controlling gas pressure of the ALD reaction chamber to a range of about $10^{-1}$ to $10^{-4}$ torr; and (j) forming a group II-VI semiconductor film with the film thickness of about 0 $\sim$ 100 nm on the substrate.

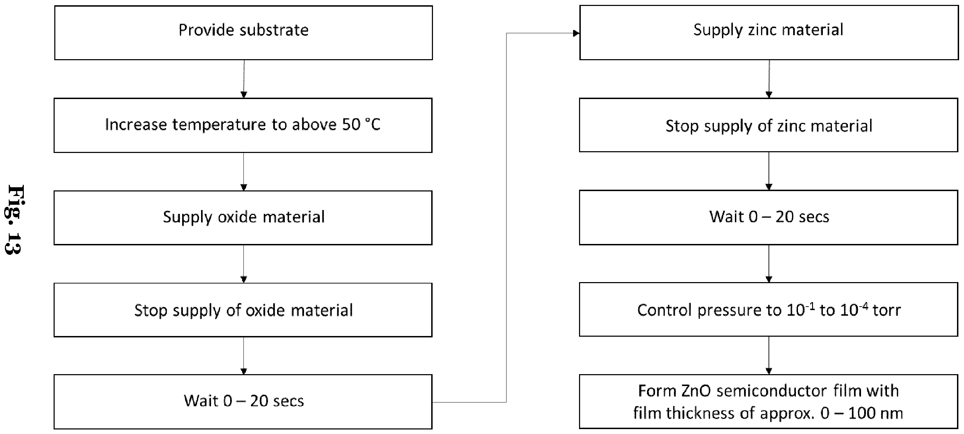

Fig. 13 illustrates another exemplary method of growing two-dimensional, group II- VI semiconductor films on a semiconductor device. The method includes:

(a) providing a substrate in an ALD reaction chamber; (b) controlling a temperature of the ALD reaction chamber to a range above of about 50 °C (e.g., about 50 °C ~ 400 °C); (c) supplying an oxide material; (d) stopping the supply of the oxide material; (e) waiting 0 ~ 20 secs after stopping the supply of the oxide material; (f) supplying a zinc material; (g) stopping the supply of the zinc material; (h) waiting 0 ~ 20 secs after stopping the supply of the zinc material; (i) controlling gas pressure of the ALD reaction chamber to a range of about $10^{-1}$ to $10^{-4}$ torr; and (j) forming a ZnO semiconductor film with the film thickness of about 0 ~ 100 nm on the substrate.

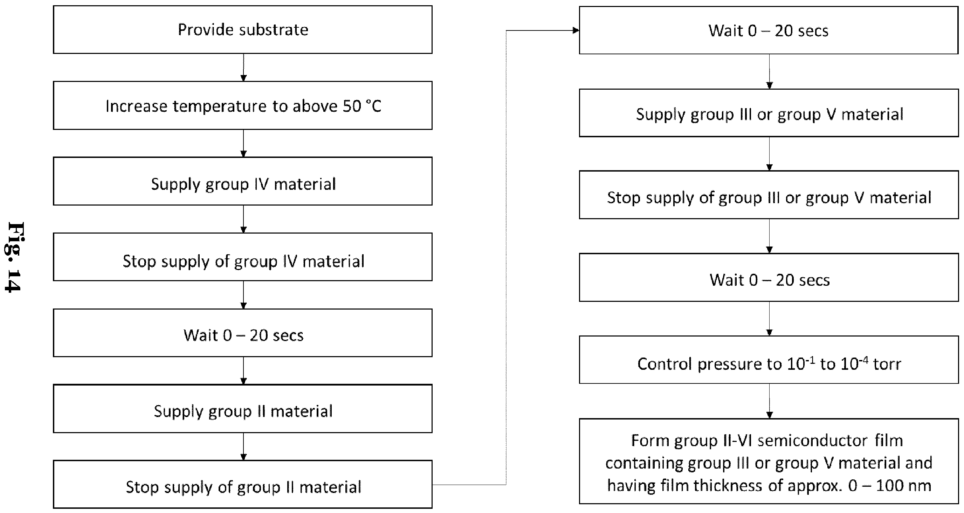

Fig. 14 illustrates another exemplary method of growing two-dimensional, group II- VI semiconductor films containing a group III or group V material on a semiconductor device. The method includes: (a) providing a substrate in an ALD reaction chamber; (b) controlling a temperature of the ALD reaction chamber to a range above of about 50 °C (e.g., about 50 °C ~ 400 °C); (c) supplying a group IV material; (d) stopping the supply of the group IV material; (e) waiting 0 ~ 20 secs after stopping the supply of the group IV material; (f) supplying a group II material; (g) stopping the supply of the group II material; (h) waiting 0 ~ 20 secs after stopping the supply of the group II material; (i) supplying a group III or group V material; (j) stopping the supply of the group III or group V material; (k) waiting 0 ~ 20 secs after stopping the supply of the group III or group V material; (1) controlling gas pressure of the ALD reaction chamber to a range of about $10^{-1}$ to $10^{-4}$ torr; and (m) forming a group II-VI semiconductor film containing the group III or group V material and having film thickness of about 0 ~ 100 nm on the substrate.

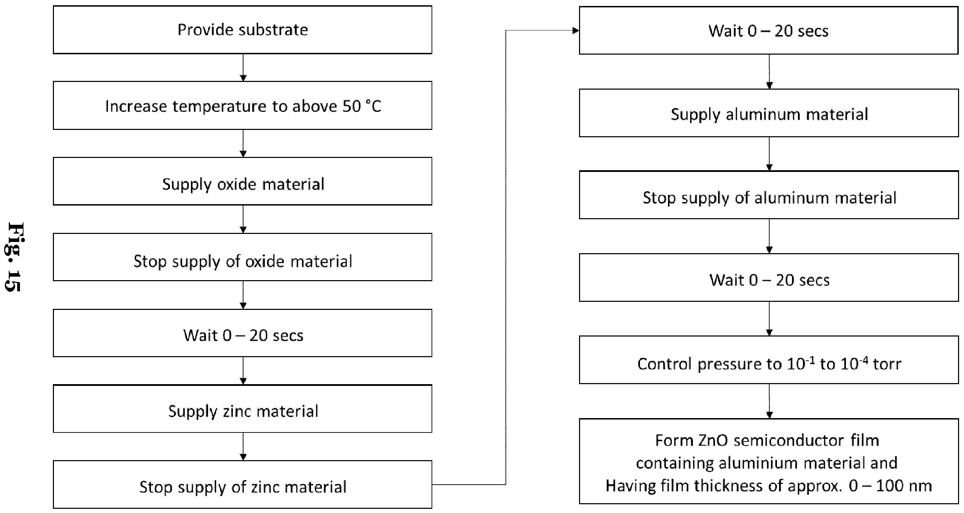

Fig. 15 illustrates another exemplary method of growing two-dimensional, group II-VI semiconductor films containing a group III or group V material on a semiconductor device. The method includes: (a) providing a substrate in an ALD reaction chamber; (b) controlling a temperature of the ALD reaction chamber to a range above of about 50 °C (e.g., about 50 °C ~ 400 °C); (c) supplying an oxide material; (d) stopping the supply of the oxide material; (e) waiting 0 ~ 20 secs after stopping the supply of the oxide material; (f) supplying a zinc material; (g) stopping the supply of the zinc material; (h) waiting 0 ~ 20 secs after stopping the supply of the zinc material; (i) supplying an aluminum material; (j) stopping the supply of the aluminum material; (k) waiting 0 ~ 20 secs after stopping the supply of the aluminum material; (1) controlling gas pressure of the ALD reaction chamber to a range of about 10 1 to $10^{-4}$ torr; and (m) forming a ZnO semiconductor film containing the aluminum material and having the film thickness of about 0 ~ 100 nm on the substrate.

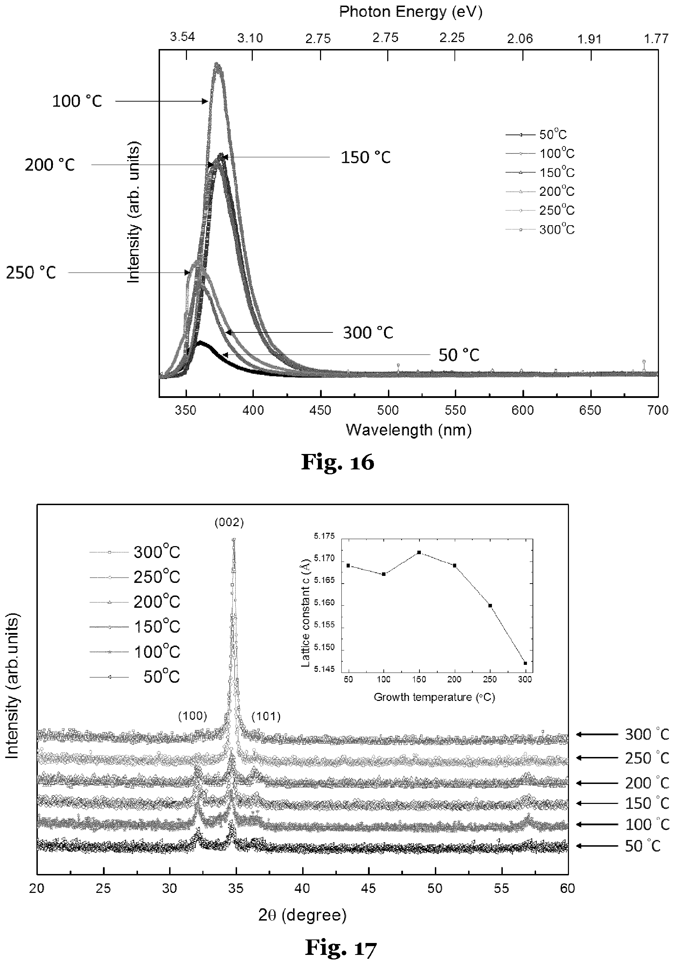

Fig. 16 illustrates PL spectra of exemplary Al-doped ZnO semiconductor films with different growth temperatures ranging from 50 °C to 300 °C when measured at room temperature. The peak center is located in the range of about 360 nm to 390 nm, which depends on the growth temperature, indicating a good optical quality.

Fig. 17 illustrates XRD spectra of exemplary Al-doped ZnO semiconductor films with different growth temperature ranging from about 50 °C to 300 °C. The XRD patterns clearly indicate that the initial increase in the temperature from 50 °C to 200 °C results in an improved crystallinity along (100) direction as the major peak intensity considerably increases up to 200 °C. Afterward the major peak intensity of the thin film decreases above 200 °C growth temperature. The change in the peak intensity is associated with the change in the lattice constants, where inset figure shows lattice constants as the function of growth temperature, indicating that the lattice constant changes in the range of about 5.17 nm to 5.14 nm when increasing growth temperature.

Other embodiments of the invention will be apparent to those skilled in the art from consideration of the specification and practice of the invention disclosed herein. It is intended that the specification and examples be considered as exemplary only, with a true scope and spirit of the invention being indicated by the following claims.

**EXAMPLES**

Further disclosed herein are the following examples:

1. A semiconductor device, comprising:

a substrate; and
a plurality of two-dimensional films over the substrate,
wherein a photogain of the two-dimensional films is above about $10^3$ when measured at room temperature.

2. The semiconductor device of example 1, wherein the two-dimensional films comprise group II or group VI material.

3. The semiconductor device of example 2, wherein the two-dimensional films comprise Zinc and Oxide.

4. The semiconductor device of example 3, wherein the two-dimensional films are ZnO films, and the thickness of the ZnO films is below about 100 nm.

5. The semiconductor device of example 4, wherein the thickness of the ZnO films is below about 5 nm.

6. The semiconductor device of one of example 1 to 5, further comprising an electrode, wherein the electrode comprises Au and is disposed on the two-dimensional films.

7. The semiconductor device of one of examples 1 to 6, further comprising an electrode, wherein the electrode is disposed on the substrate, and the substrate comprises silicon.

8. A semiconductor device, comprising
a substrate comprising nanorods; and
a plurality of two-dimensional films disposed on the nanorods substrate.

9. The semiconductor device of example 8, wherein the two-dimensional films comprise group II or group VI material.

10. The semiconductor device of example 9, wherein the two-dimensional films comprise Zinc and Oxide

11. The semiconductor device of one of examples 8 to 10, further comprising an electrode, wherein the electrode comprises Au and is disposed on the two-dimensional films on the nanorods substrate, and the nanorods substrate comprises silicon.

12. A semiconductor device, comprising
a substrate comprising nanodots; and
a plurality of two-dimensional films disposed on the nanodots substrate.

13. The semiconductor device of example 12, wherein the two-dimensional films comprise group II or group VI material.

14. The semiconductor device of example 13, wherein the two-dimensional films comprise Zinc and Oxide.

15. The semiconductor device of one of examples 12 to 14, further comprising an electrode, wherein the electrode comprises Au and is disposed on the two-dimensional films on the nanodots substrate, and the nanodots substrate comprises silicon.

16. A semiconductor device, comprising:

a substrate; and
a plurality of doped two-dimensional films, wherein the doped two-dimensional films have an average transmittance in the visible wavelength range exceeding 95 %, a mobility of above about $10^2$ cm$^2$ V$^{-1}$s$^{-1}$, and a resistivity below about $10^{-5}$ $\Omega$-cm.

17. The semiconductor device of example 16, wherein the doped two-dimensional films are doped by group III or group V material.

18. The semiconductor device of example 16 or 17, wherein the doped two-dimensional films comprise a ZnO film.

19. The semiconductor device of one of examples 16 to 18, wherein the doped two-dimensional films comprise Aluminum.

20. A semiconductor device, comprising:

a substrate comprising nanorods; and
a plurality of doped two-dimensional films disposed on the nanorods substrate.

21. The semiconductor device of example 20, wherein the doped two-dimensional films comprise group II or group VI material and group III or group V material.

22. The semiconductor device of example 21, wherein the doped two-dimensional films comprise Zinc, Oxide, and Aluminum.

23. The semiconductor device of example 22, further comprising an electrode, wherein the electrode comprises Au and is disposed on the doped two-dimensional films on the nanorods substrate, and the nanorods substrate comprises silicon.

24. The semiconductor device of example 20 or 21, further comprising an electrode, wherein the electrode comprises Au and is disposed on the doped two-dimensional films on the nanorods substrate, and the nanorods substrate comprises silicon.

25. A semiconductor device, comprising:

a substrate comprising nanodots; and
a plurality of doped two-dimensional films disposed on the nanodots substrate.

26. The semiconductor device of example 25, wherein the doped two-dimensional films comprise group II or group VI material and group III or group V material.

27. The semiconductor device of example 26, wherein the doped two-dimensional films comprise Zinc, Oxide, and Aluminum.

28. The semiconductor device of one of examples 25 to 27, further comprising an electrode, wherein the electrode comprises Au and is disposed on the doped two-dimensional films on the nanodots substrate, and the nanodots substrate comprises silicon.

29. A method of growing a two-dimensional film on a semiconductor device, the method comprising:

providing a substrate;
controlling a temperature to above about 50 °C;
supplying a group IV material;
stopping the supply of the group IV material;
supplying a group II material;
stopping the supply of the group II material; and
forming a group II-VI two-dimensional film on the substrate.

30. The method of example 29, further comprising, after stopping the supply of the group II material, setting the pressure to a range of about $10^{-1}$ to $10^{-4}$ torr.

31. The method of example 29 or 30, wherein forming the group II-VI two-dimensional film comprises forming the group II-VI two-dimensional film with a less than about 100 nm thickness on the substrate.

32. The method of one of examples 29 to 31, wherein the group II-VI two-dimensional film comprises a ZnO film.

33. A method of growing a doped two-dimensional film on a semiconductor device, the method comprising:

> providing a substrate
> controlling the temperature to above about 50 °C;
> supplying a group IV material;
> stopping the supply of the group IV material;
> supplying a group II material;
> stopping the supply of the group II material;
> supplying a group III or group V material;
> stopping the supply of the group III or group V material; and
> forming a II-VI two-dimensional film containing the group III or group V doped material on the substrate.

34. The method of example 33, further comprising, after stopping the supply of the group II material, setting the pressure to a range of about i0-1 to $10^{-4}$ torr.

35. The method of example 33 or 34, wherein forming the group II-VI two-dimensional film comprises forming the group II-VI two-dimensional film with a less than about 100 nm thickness on the substrate.

**Claims**

1. A semiconductor device, comprising:

> a substrate; and
> a plurality of two-dimensional films over the substrate,
> wherein a photogain of the two-dimensional films is above about 103 when measured at room temperature.

2. The semiconductor device of claim 1, wherein the two-dimensional films comprise group II or group VI material.

3. The semiconductor device of claim 2, wherein the two-dimensional films comprise Zinc and Oxide wherein the two-dimensional films are preferably ZnO films, and the thickness of the ZnO films is below about 100 nm, and more preferably below about 5 nm.

4. The semiconductor device of one of the preceding claims, further comprising an electrode, wherein the electrode is Fe, Co, Ni, Cu, Zn, Ag, Pt, Au, Al, In, Ti, Mn, Ge, Pb or C and disposed on the two-dimensional films, and wherein the electrode is preferably Au and thickness of electrode is preferably between about 50 nm to 2000 nm.

5. The semiconductor device of one of claims 1 to 3, further comprising an electrode, wherein the electrode is Fe, Co, Ni, Cu, Zn, Ag, Pt, Au, Al, In, Ti, Mn, Ge, Pb or C and disposed on the substrate.

6. The semiconductor device of claim 5, wherein the thickness of the electrode is between about 50 nm and 2000 nm.

7. The semiconductor device of claim 5 or 6, wherein the substrate comprises group II, group III, group V, or group VI material, wherein the substrate preferably comprises silicon, boron, or phosphorus.

8. A semiconductor device, comprising:

> a substrate; and
> a plurality of doped two-dimensional films, wherein the doped two-dimensional films have an average transmittance in the visible wavelength range exceeding 95 %, a mobility of above about $10^2$ cm$^2$ V$^{-1}$ s$^{-1}$, and a resistivity below about $10^{-5}$ $\Omega$-cm.

9. The semiconductor device of claim 8, wherein the doped two-dimensional films are doped by group III or group V material, wherein the doped two-dimensional films preferably comprise a ZnO film.

10. The semiconductor device of claim 8 or 9, wherein the doped two-dimensional films comprise Aluminum.

11. A method of growing a two-dimensional film on a semiconductor device, the method comprising:

> providing a substrate;
> controlling a temperature to above about 50 °C;
> supplying a group IV material;

stopping the supply of the group IV material;
supplying a group II material;
stopping the supply of the group II material; and
forming a group II-VI two-dimensional film on the substrate.

12. The method of claim 11, further comprising, after stopping the supply of the group II material, setting the pressure to a range of about $10^{-1}$ to $10^{-4}$ torr.

13. The method of claim 11 or 12, wherein forming the group II-VI two-dimensional film comprises forming the group II-VI two-dimensional film with a less than about 100 nm thickness on the substrate, and/or wherein the group II-VI two-dimensional film comprises a ZnO film.

14. A method of growing a doped two-dimensional film on a semiconductor device, the method comprising:

    providing a substrate
    controlling the temperature to above about 50 °C;
    supplying a group IV material;
    stopping the supply of the group IV material;
    supplying a group II material;
    stopping the supply of the group II material;
    supplying a group III or group V material;
    stopping the supply of the group III or group V material; and
    forming a II-VI two-dimensional film containing the group III or group V doped material on the substrate.

15. The method of claim 14, further comprising, after stopping the supply of the group II material, setting the pressure to a range of about $10^{-1}$ to $10^{-4}$ torr, and/or wherein forming the group II-VI two-dimensional film comprises forming the group II-VI two-dimensional film with a less than about 100 nm thickness on the substrate.

Light shining

LT I

Light shining

LT III

Electrode (Au)

$I_{Au-ZnO}$  ZnO

$I_{ZnO-silicon}$

Substrate (Si)

Electrode

V

**Fig. 1**

| Au | ZnO/sub (Si) |
|---|---|

Light shining

Light shining

LT I

LT III

−

+

**Fig. 2**

Light shining

⇩ LT I

nanorod

Light shining

⇩ LT III

**Electrode (Au)**

$I_{Au-ZnO}$

**ZnO**

⇩ $I_{ZnO-silicon}$

**Substrate (Si)**

**Electrode**

Ⓥ

**Fig. 3**

**Fig. 4**

**Fig. 5**

**Fig. 6**

**Fig. 7**

**Fig. 8**

Fig. 9

Fig. 10

**Fig. 11**

**Fig. 12**

| Supply zinc material | → | Stop supply of zinc material | → | Wait 0 – 20 secs | → | Control pressure to $10^{-1}$ to $10^{-4}$ torr | → | Form ZnO semiconductor film with film thickness of approx. 0 – 100 nm |

| Provide substrate | → | Increase temperature to above 50 °C | → | Supply oxide material | → | Stop supply of oxide material | → | Wait 0 – 20 secs |

**Fig. 13**

Wait 0 – 20 secs

Supply group III or group V material

Stop supply of group III or group V material

Wait 0 – 20 secs

Control pressure to $10^{-1}$ to $10^{-4}$ torr

Form group II-VI semiconductor film containing group III or group V material and having film thickness of approx. 0 – 100 nm

Provide substrate

Increase temperature to above 50 °C

Supply group IV material

Stop supply of group IV material

Wait 0 – 20 secs

Supply group II material

Stop supply of group II material

**Fig. 14**

Provide substrate → Increase temperature to above 50 °C → Supply oxide material → Stop supply of oxide material → Wait 0 – 20 secs → Supply zinc material → Stop supply of zinc material →

Wait 0 – 20 secs → Supply aluminum material → Stop supply of aluminum material → Wait 0 – 20 secs → Control pressure to $10^{-1}$ to $10^{-4}$ torr → Form ZnO semiconductor film containing aluminium material and Having film thickness of approx. 0 – 100 nm

**Fig. 15**

**Fig. 16**

**Fig. 17**

Europäisches
Patentamt

European
Patent Office

Office européen
des brevets

# EUROPEAN SEARCH REPORT

Application Number

EP 18 16 8794

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/134515 A1 (UNIV LELAND STANFORD JUNIOR [US]; HONDA PATENTS & TECH NORTH AM [US]) 4 September 2014 (2014-09-04) * page 3, line 19 - page 13, line 3 * ----- | 1-15 | INV. H01L31/0352 H01L31/074 H01L31/109 H01L31/18 |
| X | UM HAN-DON ET AL: "Highly selective spectral response with enhanced responsivity of n-ZnO/p-Si radial heterojunction nanowire photodiodes", APPLIED PHYSICS LETTERS, A I P PUBLISHING LLC, US, vol. 98, no. 3, 18 January 2011 (2011-01-18), pages 33102-33102, XP012139237, ISSN: 0003-6951, DOI: 10.1063/1.3543845 * the whole document * ----- | 1-15 | |
| X | PURNIMA HAZRA ET AL: "Ultraviolet Photodetection Properties of ZnO/Si Heterojunction Diodes Fabricated by ALD Technique Without Using a Buffer Layer", JSTS:JOURNAL OF SEMICONDUCTOR TECHNOLOGY AND SCIENCE, vol. 14, no. 1, 28 February 2014 (2014-02-28), pages 117-123, XP055508387, ISSN: 1598-1657, DOI: 10.5573/JSTS.2014.14.1.117 * I. Introduction II. Experimental Details * ----- -/-- | 1-9, 11-15 | |

TECHNICAL FIELDS SEARCHED (IPC)

H01L

The present search report has been drawn up for all claims

| Place of search | Date of completion of the search | Examiner |
|---|---|---|
| Berlin | 20 September 2018 | Rodríguez-Gironés, M |

EPO FORM 1503 03.82 (P04C01)

page 1 of 2

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KANG HYEMIN ET AL: "n-ZnO:N/p-Si nanowire photodiode prepared by atomic layer deposition", APPLIED PHYSICS LETTERS, A I P PUBLISHING LLC, US, vol. 100, no. 4, 23 January 2012 (2012-01-23), pages 41117-41117, XP012156927, ISSN: 0003-6951, DOI: 10.1063/1.3679078 [retrieved on 1901-01-01] | 1-3,7-9, 11-15 | |
| A | * the whole document * | 4-6,10 | |

TECHNICAL FIELDS
SEARCHED      (IPC)

The present search report has been drawn up for all claims

| Place of search | Date of completion of the search | Examiner |
|---|---|---|
| Berlin | 20 September 2018 | Rodríguez-Gironés, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 16 8794

20-09-2018

| Patent document cited in search report | Publication date | Patent family member(s) | Publication date |
|---|---|---|---|
| WO 2014134515 A1 | 04-09-2014 | NONE | |

For more details about this annex : see Official Journal of the European Patent Office, No. 12/82